Europäisches Patentamt

European Patent Office

Office européen des brevets

(11) Numéro de publication: **0 228 960**
**A1**

## (12) DEMANDE DE BREVET EUROPEEN

(21) Numéro de dépôt: **86402865.9**

(22) Date de dépôt: **19.12.86**

(51) Int. Cl.⁴: **H 03 M 1/74**

(30) Priorité: **24.12.85 FR 8519126**

(43) Date de publication de la demande:
**15.07.87 Bulletin 87/29**

(84) Etats contractants désignés: **DE GB NL**

(71) Demandeur: **THOMSON-CSF**
**173, Boulevard Haussmann**
**F-75379 Paris Cedex 08 (FR)**

(72) Inventeur: **Tung, Pham Ngu**
**THOMSON-CSF SCPI 19, avenue de Messine**
**F-75008 Paris (FR)**

(74) Mandataire: **Taboureau, James et al**
**THOMSON-CSF SCPI 19, avenue de Messine**
**F-75008 Paris (FR)**

(54) Source de courant programmable, et convertisseur numérique-analogique comportant une telle source.

(57) L'invention concerne un convertisseur numérique-analogique.

Celui-ci est composé d'une source de courant programmable (10) et d'un convertisseur courant-tension (15). La source comporte autant de transistors (11 à 14) qu'il y a de bits dans le signal numérique d'entrée, adressé sur les grilles (31 à 34) des transistors. Ceux-ci sont chargés chacun par une résistance saturable (21 à 24) : les valeurs des charges saturables sont telles que les courants qui les traversent sont en progression géométrique ($i_o$, $2i_o$, $4i_o$, $8i_o$). Toutes les charges satruables (21 à 24) sont réunies à un point commun (S) avec le drain et la grille d'un transistor (15) convertisseur de courant en tension : la tension analogique sur la sortie S, est linéaire avec le signal numérique sur les entrées (31 à 34).

Application aux matériels hyperfréquences, sous forme de circuit intgré sur GaAs-AlGaAs.

FIG_1

EP 0 228 960 A1

## Description

SOURCE DE COURANT PROGRAMMABLE ET CONVERTISSEUR NUMERIQUE-ANALOGIQUE
COMPORTANT UNE TELLE SOURCE

La présente invention concerne une source de courant programmable, et son application à un convertisseur numérique-analogique. L'invention, qui peut être mise en oeuvre avec tous les types de transistors, est plus particulièrement intéressante avec des transistors rapides à hétérojonction, surtout sous forme de circuit intégré rapide réalisé avec des matériaux du groupe III-V tels que GaAs et AlGaAs.

C'est un objet de l'invention que de proposer un circuit qui assure la conversion rapide de signaux logiques, dits numériques, en signaux analogiques, car les convertisseurs connus ne travaillent bien souvent qu'à quelques dizaines de mégahertz : pour pouvoir travailler à quelques dizaines de gigahertz, il faut allier la grande rapidité des transistors en matériaux III-V, notamment ceux qui utilisent un gaz d'électrons bidimensionel, à un circuit simple, ne comportant qu'un minimum d'étages, dont un minimum de temps de transit à travers les étages.

C'est également un objet de l'invention que de proposer un circuit dont la technologie soit homogène, ce qui facilite sa réalisation en circuit intégré, avec un bon rendement industriel. Le circuit selon l'invention ne comporte que des transistors et des charges saturables, dont une forme de réalisation est celle d'un transistor sans grille.

La source de courant programmable selon l'invention comporte une pluralité de transistors montés en parallèle : ils ne constituent donc qu'un seul étage. Alimentés par leurs drains, ces transistors ont leurs sources réunies à des résistances saturables, une par transistor, dont les valeurs sont en progression géométrique. Les signaux binaires adressés sur les grilles des transistors font que ceux-ci débitent à travers les résistances des courants en progression géométrique. Comme toutes les résistances saturables sont réunies ensemble par leur extrémité qui n'est pas réunie à une source de transistor, le courant débité par cette source de courant est égal à la somme de tous les courants débités par les résistances en parallèle.

Pour obtenir un convertisseur numérique-analogique, cette source de courant programmable est complétée par un transistor convertisseur de courant en tension. Il est monté drain et grille réunis, connectés au point commun à toutes les résistances saturables, et sa source est réunie à une tension de référence. La sortie du convertisseur numérique-analogique est prise au point commun entre les résistances saturables et le drain du transistor convertisseur de courant en tension.

De façon plus précise, l'invention concerne une source de courant programmable, comportant une pluralité d'entrées et une seule sortie, caractérisée en ce qu'elle comprend une même pluralité de sources élémentaires de courant montées en parallèle, chacune de ces sources élémentaires étant constituée par un transistor dont :
- une première électrode d'accès est polarisée par une tension
- l'électrode de commande constitue une entrée de la source de courant programmable,
- une deuxième électrode d'accès est réunie à une résistance saturable, à courant constant,
les résistances saturables des sources élémentaires ayant des valeurs telles que les courants qui les traversent présentent une progression géométrique, la sortie de la source de courant programmable, prise en un point commun à toutes les résistances saturables, délivrant un courant égal à la somme des courants des sources élémentaires.

L'invention sera mieux comprise par la description suivante d'un exemple de réalisation de convertisseur numérique-analogique, en s'appuyant sur les figures jointes en annexe qui représentent :
- Figure 1 : schéma électrique d'un convertisseur numérique-analogique selon l'invention,
- Figure 2 : schéma électrique d'un convertisseur avec son circuit de commande, selon l'invention.

Il a été dit que le circuit selon l'invention est applicable à tous les types de transistors, ayant donc deux électrodes d'accès et une électrode de commande : émetteur, collecteur et base, respectivement, s'il s'agit de transistors bipolaires, source, drain et grille, respectivement, s'il s'agit de transistors à effet de champs. En raison de l'intérêt du circuit aux très hautes fréquences, et dans le seul objectif de simplifier l'expression dans le texte, l'invention sera exposée, sans limitation du domaine qu'elle couvre, en s'appuyant sur le cas des transistors à effet de champs.

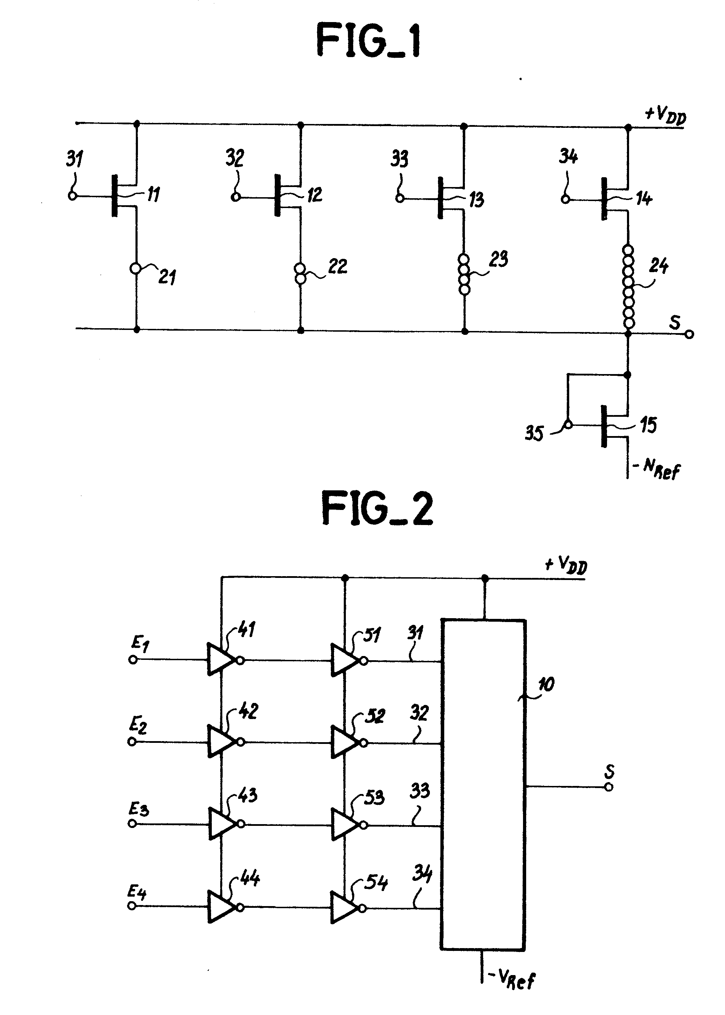

La figure 1 représente le schéma électrique d'un convertisseur numérique-analogique selon l'invention.
Il comprend deux parties :
- une source de courant programmable,
- un convertisseur courant-tension.

La source de courant programmable comprend une pluralité de transistors 11, 12, 13, 14 montés en parallèle : il y a autant de transistors que de bits dans le signal numérique. La représentation de la figure 1, avec quatre transistors, correspond donc à un signal de quatre bits, ce qui ne limite pas la portée de l'invention. Tous ces transistors sont alimentés par leur drain par une tension $+V_{DD}$.

Ils sont montés en source suiveuse, chaque source étant en série avec une résistance, 21 à 24, qui sera détaillée plus loin. Toutes les extrémités libres des résistances, c'est-à-dire celles qui ne sont pas connectées aux sources des transistors, sont réunies.

Sur les grilles 31 à 34 des transistors 11 à 14 sont appliqués les tensions du signal d'entrée : si par exemple le signal d'entrée est de la forme numérique 1011, la première grille 31 reçoit un signal 1, la deuxième grille 32 reçoit un signal 0 et les troisième et quatrième grilles 33 et 34 reçoivent chacune un signal 1. Bien entendu, il faut que les niveaux de tensions des 1 soient suffisants pour amener les transistors 11 à 14 à saturation : c'est le rôle du circuit de commande, ou buffer, qui sera développé à l'occasion de la figure 2.

Le signal de sortie de cette source de courant programmable est pris en S au point commun à toutes les résistances 21 à 24.

Les résistances 21 à 24 ont deux caractéristiques.

D'abord, ce sont toutes des résistances saturables, c'est-à-dire que leur caractéristique courant/tension n'est pas linéaire selon la loi d'Ohm, mais présente une asymptote : si le transistor correspondant est saturé, le courant qui le traverse est limité par la valeur de la résistance saturable à laquelle il est relié. Donc, des transistors identiques débitent des courants maximaux déterminés par les résistances saturables auxquelles ils sont reliés. On sait que les résistances saturables, connues, sont constituées par exemple par :
- des transistors sans grille,
- des transistors dont le canal est creusé, sans grille,
- des transistors comportant des trous dans l'épaisseur du canal sous la métallisation de grille.

Ensuite, les résistances saturables 21 à 24 ont des valeurs de résistances telles que les courants qui les traversent ont des valeurs variant selon une progression géométrique, considérée selon l'ordre des bits du signal d'entrée.

Ainsi, si le premier bit est adressé sur le transistor 11, le deuxième bit sur le transistor 12 etc... les courants qui traversent les résistances saturables sont donnés par :

$$1\text{er bit } I_{21} = i_o$$
$$2\text{e bit } I_{22} = 2i_o$$
$$3\text{e bit } I_{23} = 4i_o$$
$$4\text{e bit } I_{24} = 8i_o \text{ etc...}$$

Les résistances 21 à 24 n'étant pas des résistances conventionnelles, elles sont représentées en figure 1 par un symbole non conventionnel, qui rappelle la progression géométrique du courant qui les traverse.

Tous les transistors 11 à 14 de la source de courant étant montés en parallèle, le courant débité par la source est égal à la somme de tous les courants débités par les résistances saturables 21 à 24. Ce courant est transformé en une tension par un transistor à effet de champ 15.

Celui-ci est monté grille et drain réunis entre eux et au point commun à toutes les résistances saturables 21 à 24, sa source étant polarisée par une tension de référence $-V_{ref}$ : l'ensemble de la source de courant programmable et du convertisseur courant-tension est donc alimenté entre $-V_{ref}$ et $+V_{DD}$.

La sortie S du convertisseur numérique-analogique est prise sur le drain du transistor 15 convertisseur de courant en tension : un signal de tensions numériques est adressé sur les grilles 31 à 34 des transistors 11 à 14, et un signal de tension analogique est délivré sur le drain du transistor 15.

Le courant qui traverse le transistor 15 est de la forme :

$$I_{15} = g_m (V_S - V_{Ref} - V_T)$$

avec :

$g_m$ : transconductance du transistor 15

$V_S$ = tension de sortie en S, sur le drain

$V_{Ref}$ : tension de référence, sur la source

$V_T$ : tension de seuil du transistor.

Mais ce courant est aussi égal à la somme des courants qui traversent les résistances saturables 21 à 24, soit :

$$I_{15} = (NL_{31}) i_o + 2(NL_{32}) i_o + 4(NL_{33}) i_o + 8(NL_{34}) i_o \text{avec :}$$

$(NL_{xy})$ = niveau logique de la grille d'indice xy

$NL = 0$ si le niveau logique appliqué sur la grille est 0

$(NL) = 1$ si le niveau logique appliqué sur la grille est 1

Ces deux relations montrent que la tension de sortie $V_S$ est une fonction linéaire des niveaux logiques appliqués sur les grilles des transistors 11 à 14.

Le tableau suivant donne les tensions de sortie $V_S$ en fonction des niveaux logiques des entrées 31 à 34, pour un convertisseur à 4 bits. On écrit pour s'implifier :

$$V_o = V_{Ref} + V_T$$

et $u = i_o/g_m$

| $NL_{31}$ | $NL_{32}$ | $NL_{33}$ | $NL_{34}$ | $I_{15}$ | $V_S$ |
|---|---|---|---|---|---|
| 0 | 0 | 0 | 0 | 0 | $V_o$ |
| 1 | 0 | 0 | 0 | $i_o$ | $V_o + u$ |
| 0 | 1 | 0 | 0 | $2i_o$ | $V_o + 2u$ |
| 1 | 1 | 0 | 0 | $3i_o$ | $V_o + 3u$ |
| 0 | 0 | 1 | 0 | $4i_o$ | $V_o + 4u$ |
| 1 | 0 | 1 | 0 | $5i_o$ | $V_o + 5u$ |
| 0 | 1 | 1 | 0 | $6i_o$ | $V_o + 6u$ |
| 1 | 1 | 1 | 0 | $7i_o$ | $V_o + 7u$ |
| 0 | 0 | 0 | 1 | $8i_o$ | $V_o + 8u$ |
| 1 | 0 | 0 | 1 | $9i_o$ | $V_o + 9u$ |
| 0 | 1 | 0 | 1 | $10i_o$ | $V_o + 10u$ |
| 1 | 1 | 0 | 1 | $11i_o$ | $V_o + 11u$ |
| 0 | 0 | 1 | 1 | $12i_o$ | $V_o + 12u$ |
| 1 | 0 | 1 | 1 | $13i_o$ | $V_o + 13u$ |
| 0 | 1 | 1 | 1 | $14i_o$ | $V_o + 14u$ |
| 1 | 1 | 1 | 1 | $15i_o$ | $V_o + 15u$ |

De façon générale, la transconductance $g_m$ est une fonction du courant qui traverse un transistor. Mais dans le cas des transistors à hétérojonction, GaAs/AlGaAs par exemple, et à gaz d'électrons bidimensionnel, la

transconductance $g_m$ est quasiment constante, et indépendante du courant $I_{15}$ qui traverse le transistor. Le convertisseur numérique-analogique selon l'invention donne donc une réponse de sortie linéaire par rapport au signal d'entrée.

Le convertisseur selon l'invention peut nécessiter, dans certains cas, un circuit de commande, dont le schéma simplifié est donné en figure 2.

En effet, les niveaux 0 logique et 1 logique qui sont appliqués sur les grilles 31 à 34 sont des niveaux relatifs, qui sont parfois de faible valeur, et toujours inférieurs à 1 volt. Ils peuvent donc être inférieurs à la tension de seuil de certains transistors, ce qui signifie que le niveau 1 logique ne rend plus conducteur les transistors.

On peut amplifier ces niveaux logiques, mais une solution simple, représentée en figure 2, consiste à disposer deux inverseurs en série sur chaque entrée du convertisseur numérique-analogique 10. Par exemple, la grille 31 du transistor 11 du convertisseur 10 est attaquée par le signal d'entrée $E_1$ à travers un inverseur 41 en série avec un inverseur 51, tous deux alimentés par une tension $+V_{DD}$, qui peut être celle qui alimente le convertisseur 10, mais qui en tous cas est supérieure à la tension de seuil des transistors 11 à 14. Si, à titre d'exemple, le signal numérique $E_1$ est un 1 logique, de faible niveau, le signal de sortie de l'inverseur 41 est un 0 logique et le signal de sortie de l'inverseur 51 est un 1 logique, de niveau $+V_{DD}$, supérieur à la tension de seuil des transistors 11 à 14.

Le convertisseur numérique-analogique selon l'invention ne comporte qu'un seul étage de transistors 11 à 14 dans le cas où les signaux d'entrée sont d'un niveau supérieur à la tension de seuil des dits transistors, ou, ce qui revient au même, si ces transistors sont choisis pour leur tension de seuil faible et inférieure au niveau 1 logique d'entrée.

Dans le cas contraire, le convertisseur numérique-analogique selon l'invention comporte trois étages de transistors, deux dans le circuit de commande, et un dans le convertisseur 10. Mais dans tous les cas, le convertisseur selon l'invention est un circuit extrêmement rapide, fonctionnant à plusieurs dizaines de gigahertz.

Bien entendu, l'invention n'est pas limitée à un convertisseur à 4 bits, comme représenté en figures 1 et 2. Il convient au contraire d'observer que pour un convertisseur à n bits, comportant n transistors 11, 12...n, montés en parallèle, la vitesse de conversion est constante, quel que soit le nombre de bits ou de transistors, puisque la source de courant ne comprend dans tous les cas qu'un seul étage.

Ce convertisseur numérique-analogique est utilisé dans le traitement de signaux hyperfréquences, pour les télécommunications ou les radars par exemple.

Il est précisé par les revendications suivantes.

## Revendications

1. Source de courant programmable, comportant une pluralité d'entrées et une seule sortie, caractérisée en ce qu'elle comprend une même pluralité de sources élémentaires de courant montées en parallèle, chacune de ces sources élémentaires étant constituée par un transistor (11 à 14) dont :
- une première électrode d'accès est polarisée par une tension ($+V_{DD}$)
- l'électrode de commande (31 à 34) constitue une entrée de la source de courant programmable,
- une deuxième électrode d'accès est réunie à une résistance saturable (21 à 24), à courant constant,
les résistances saturables (21 à 24) des sources élémentaires ayant des valeurs telles que les courants qui les traversent présentent une progression géométrique ($i_o, 2i_o, 4i_o, 8i_o...$), la sortie (S) de la source de courant programmable, prise en un point commun à toutes les résistances saturables (21 à 24), délivrant un courant égal à la somme des courants ($i_o, 2i_o...$) des sources élémentaires.

2. Source de courant programmable selon la revendication 1, caractérisé en ce que les transistors (11 à 14) des sources élémentaires sont des transistors à effet de champ, dont l'électrode polarisée (à $+V_{DD}$) est le drain, et dont l'électrode réunie à une résistance saturable (21 à 24) est la source, les grilles (31 à 34) de ces transistors constituant les entrées de la source de courant programmable.

3. Source de courant programmable selon la revendication 1, caractérisé en ce que les résistances saturables (31 à 34) sont des transistors qui :
- soit n'ont pas de grille,
- soit ont une région de canal creusée, sans grille,
- soit ont une grille, mais une région de canal percée de trous.

4. Convertisseur numérique-analogique, transformant un signal numérique d'entrée comportant une pluralité de bits en un signal analogique de sortie, caractérisé en ce qu'il comporte :
- une source de courant programmable selon la revendication 2, comportant la même pluralité de transistors (11 à 24) qu'il y a de bits dans le signal numérique d'entrée, les dits bits du signal d'entrée étant dans l'ordre de la progression géométrique des courants qui traversent les résistances saturables (21 à 24),
- un convertisseur courant-tension, constitué par un transistor à effet de champ (15), dont la source est alimentée par une tension de référence ($-V_{Ref}$), et dont la grille et le drain sont réunis au point commun à toutes les résistances saturables (21 à 24) et à la sortie (S) du convertisseur numérique-analogique.

5. Convertisseur numérique-analogique selon la revendication 4, caractérisé en ce que les transistors de la source de courant programmable (11 à 14) et du convertisseur courant-tension (15) sont des transistors en matériaux du groupe III-V tels que GaAs-AlGaAs, à hétérojonction à gaz d'électrons bidimentionnel.

6. Convertisseur numérique analogique selon la revendication 5, caractérisé en ce que la transconductance ($g_m$) des transistors à gaz d'électrons bidimentionnel étant indépendante du courant qui les travers, le signal analogique de sortie (S) du convertisseur est une fonction linéaire du signal numérique d'entrée.

7.Convertisseur numérique-analogique selon la revendication 4, caractérisé en ce que, les bits du signal numérique d'entrée étant adressés en parallèle sur les transistors (11 à 14) de la source de courant programmable, la vitesse de conversion numérique- analogique du convertisseur est indépendante du nombre de bits du signal d'entrée.

8. Convertisseur numérique-analogique selon la revendication 4, caractérisé en ce que, si le niveau logique du signal d'entrée ($E_1$ à $E_4$) est inférieur à la tension de seuil ($V_T$) des transistors (11 à 14) de la source de courant programmable, le convertisseur est commandé par un circuit de commande constitué, pour chaque entrée (31, 34) de la source de courant programmable (10), par deux inverseurs en série (41, 51) qui délivrent des niveaux 1 logiques supérieurs à la tension de seuil ($V_T$) des transistors (11 à 14).

# FIG_1

# FIG_2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| X | DE-A-2 412 226 (TEXAS INSTRUMENTS DEUTSCHLAND) <br> * Page 3, ligne 19 - page 6, ligne 18; figure 1 * | 1,4 | H 03 M 1/74 |
| A | | 6 | |
| | --- | | |
| X | FR-A-2 469 836 (HENNION et al.) <br> * Page 3, ligne 4 - page 5, ligne 1; figure 1 * | 1-2 | |
| | --- | | |
| X | US-A-2 954 551 (DOUCETTE et al.) <br> * Colonne 2, ligne 67 - colonne 3, ligne 29; figure 3 * | 1,3 | |
| | ----- | | **DOMAINES TECHNIQUES RECHERCHES (Int. Cl.4)** <br><br> H 03 M 1/74 |

Le présent rapport de recherche a été établi pour toutes les revendications

| Lieu de la recherche | Date d'achèvement de la recherche | Examinateur |
|---|---|---|
| LA HAYE | 03-03-1987 | GUIVOL Y. |